# DEMANDE DE BREVET EUROPEEN

(11) **EP 3 244 535 A1**
(43) Date de publication de la demande: **15.11.2017**
(21) Numéro de dépôt: 17170262.4
(22) Date de dépôt: 09.05.2017
(51) Int. Cl.: H03K 17/082

(54) **SYSTÈME D'INTERRUPTEUR ET CONVERTISSEUR ÉLECTRIQUE COMPORTANT UN TEL SYSTÈME D'INTERRUPTEUR**

(30) Priorité: 11.05.2016 FR 1654183
(71) Demandeur: Valeo Systemes de Controle Moteur, 95800 Cergy Saint Christophe (FR)
(72) Inventeur: BERTRAND, Mathieu, 94046 Creteil (FR); NIKOLIC, David, 95800 Cergy Saint Christophe (FR); PLAIDEAU, Michel, 95800 Cergy Saint Christophe (FR)
(74) Mandataire: Cardon, Nicolas

(57) **Abrégé**

Le système d'interrupteur comporte : un interrupteur (104₁) comportant une première borne (D₁), une deuxième borne (S₁) et une borne de commande (G₁), la première borne (D₁) et la deuxième borne (S₁) présentant entre elles une première tension (Vds₁), la borne de commande (G₁) et la deuxième borne (S₁) présentant entre elles une deuxième tension (Vgs₁) contrôlant la première tension (Vds₁); un circuit de limitation de tension (128₁) comportant une première borne (136₁) ; une connexion de rétroaction (CR₁) entre la première borne (136₁) du circuit de limitation de tension (128₁) et la borne de commande (G₁) de l'interrupteur (104₁). Le circuit de limitation de tension (128₁) est conçu pour, dans un mode actif, réaliser une rétroaction de la première tension (Vds₁) sur la deuxième tension (Vgs₁) de manière à limiter la première tension (Vds₁). Le circuit de limitation de tension (128₁) est en outre conçu pour, dans son mode actif, fournir un courant (i₁) par sa première borne (136₁).

Le système d'interrupteur comporte en outre un dispositif de blocage de courant (122₁) conçu pour empêcher le courant (i₁) fourni par le circuit de limitation de tension (128₁) de s'écouler dans la connexion de rétroaction (CR₁) jusqu'à la borne de commande (G₁) de l'interrupteur (104₁).

## Description

### DOMAINE TECHNIQUE

La présente invention concerne le domaine des interrupteurs commandés, en particulier dans des applications où ces interrupteurs sont destinés à être parcourus par des courants supérieurs à 100 A.

### ARRIÈRE-PLAN TECHNOLOGIQUE

La demande de brevet européen publiée sous le numéro EP 2 549 649 A1 décrit un système d'interrupteur comportant :
- un interrupteur comportant :
   - une première borne,
   - une deuxième borne, et
   - une borne de commande,
   la première borne et la deuxième borne présentant entre elles une première tension,
   la borne de commande et la deuxième borne présentant entre elles une deuxième tension contrôlant la première tension,
- un circuit de limitation de tension comportant une première borne,
- une connexion de rétroaction entre la première borne du circuit de limitation de tension et la borne de commande de l'interrupteur,
   le circuit de limitation de tension étant conçu pour, dans un mode actif, réaliser une rétroaction de la première tension sur la deuxième tension de manière à limiter la première tension,
   le circuit de limitation de tension étant en outre conçu pour, dans son mode actif, fournir un courant par sa première borne.

Dans la publication précédente, le circuit de limitation de tension est destiné à limiter la première tension lors de l'ouverture de l'interrupteur. Cependant, lorsque l'interrupteur est à l'état ouvert et qu'une tension élevée est appliquée entre la première borne et la deuxième borne, les inventeurs ont remarqué qu'une reconduction non souhaitée de l'interrupteur pouvait se produire, c'est-à-dire une circulation de courant entre la première borne et la deuxième borne de l'interrupteur.

L'invention a pour but de proposer un système d'interrupteur permettant de remédier, au moins en partie, aux reconductions non souhaitées de l'interrupteur.

### RÉSUMÉ DE L'INVENTION

À cet effet, il est proposé un système d'interrupteur comportant :
- un interrupteur comportant :
   - une première borne,
   - une deuxième borne, et
   - une borne de commande,
   la première borne et la deuxième borne présentant entre elles une première tension,
   la borne de commande et la deuxième borne présentant entre elles une deuxième tension contrôlant la première tension,
- un circuit de limitation de tension comportant une première borne,
- une connexion de rétroaction entre la première borne du circuit de limitation de tension et la borne de commande de l'interrupteur,
   le circuit de limitation de tension étant conçu pour, dans un mode actif, réaliser une rétroaction de la première tension sur la deuxième tension de manière à limiter la première tension,
   le circuit de limitation de tension étant en outre conçu pour, dans son mode actif, fournir un courant par sa première borne,
caractérisé en ce qu'il comporte en outre :
- un dispositif de blocage de courant conçu pour empêcher le courant fourni par le circuit de limitation de tension de s'écouler dans la connexion de rétroaction jusqu'à la borne de commande de l'interrupteur.

En effet, les inventeurs ont remarqué que la reconduction non souhaitée provenait d'une charge de la borne de commande de l'interrupteur par le courant fourni par le circuit de limitation de tension en mode actif. Grâce à l'invention, ce courant ne peut plus circuler dans la connexion de rétroaction jusqu'à la borne de commande et ne peut donc plus charger cette dernière.

De façon optionnelle, la connexion de rétroaction comporte le dispositif de blocage de courant.

De façon optionnelle également, le système d'interrupteur comporte en outre une interface comportant une première connexion de commande connectée, à une extrémité, à la borne de commande de l'interrupteur et conçue pour recevoir, à une autre extrémité, une tension de commande, la première connexion de commande ayant une partie commune avec la connexion de rétroaction et comportant une première résistance, ainsi que, sur cette partie commune, le dispositif de blocage de courant.

De façon optionnelle également, l'interface comporte en outre une deuxième connexion de commande connectée, à une extrémité, à la borne de commande de l'interrupteur et conçue pour recevoir, à une autre extrémité, la tension de commande, la deuxième connexion de commande comportant une deuxième résistance.

De façon optionnelle également, la deuxième connexion de commande comporte en outre une diode agencée pour empêcher du courant de s'écouler dans la deuxième connexion de commande depuis la borne de commande de l'interrupteur.

De façon optionnelle également, le dispositif de blocage de courant comporte une diode.

De façon optionnelle également, le circuit de limitation de tension comporte une deuxième borne connectée à la première borne de l'interrupteur et une diode Zener agencée, avant claquage, pour empêcher du courant d'entrer dans le circuit de limitation de tension par sa deuxième borne.

De façon optionnelle également, le circuit de limitation de tension comporte une diode agencée pour empêcher du courant d'entrer dans le circuit de limitation de tension par sa première borne.

De façon optionnelle également, l'interrupteur comporte un MOSFET.

Il est également proposé un convertisseur électrique comportant au moins deux bras de commutation ayant chacun deux interrupteurs connectés l'un à l'autre en un point milieu, et dans lequel chacun d'au moins un des interrupteurs, de préférence tous, fait partie d'un système d'interrupteur selon l'invention.

### DESCRIPTION DES FIGURES

La figure 1 est un schéma électrique d'un convertisseur électrique mettant en oeuvre l'invention.
La figure 2 est une série de chronogrammes illustrant l'évolution au cours du temps de différentes grandeurs électriques du convertisseur électrique de la figure 1.

### DESCRIPTION DÉTAILLÉE

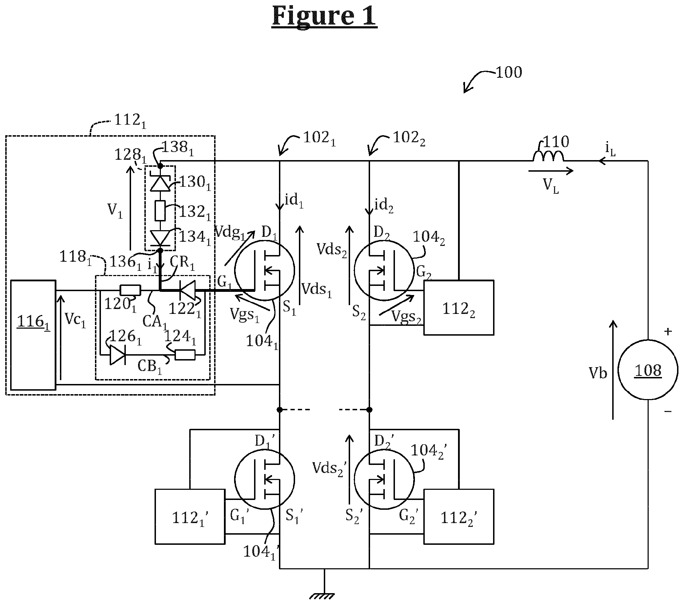

En référence à la figure 1, un convertisseur électrique 100 mettant en oeuvre l'invention va à présent être décrit.

Le convertisseur électrique 100 comporte plusieurs bras de commutation. Dans l'exemple décrit, le convertisseur électrique 100 comporte deux bras de commutation, désignés respectivement par les références 102₁ et 102₂. Dans la suite de la description, l'indice « 1 » sera utilisé pour les éléments se rapportant au premier bras de commutation 102₁, tandis que l'indice « 2 » sera utilisé pour les éléments se rapportant au deuxième bras de commutation 102₂.

Chaque bras de commutation 102₁, 102₂ comporte un interrupteur de côté haut 104₁, 104₂ et un interrupteur de côté bas 104₁', 104₂'. Dans la suite de la description, le signe prime « ' » sera utilisé pour désigner les éléments se rapportant au côté bas.

Chaque interrupteur 104₁, 104₁', 104₂, 104₂' présente une première borne D₁, D₁', D₂, D₂' une deuxième borne S₁, S₁', S₂, S₂' et une borne de commande G₁, G₁', G₂, G₂' et est conçu pour prendre sélectivement un état ouvert et un état fermé en fonction de la tension entre sa deuxième borne S₁, S₁', S₂, S₂' et sa borne de commande G₁, G₁', G₂, G₂'.

Dans l'exemple décrit, les interrupteurs 104₁, 104₁', 104₂, 104₂' sont des MOSFET (de l'anglais *« Metal Oxide Semiconductor Field Effect Transistor »* soit : transistor à effet de champ à grille isolée) présentant un drain, une source et une grille, formant respectivement la première borne, la deuxième borne et la borne de commande. Par soucis de clarté, les termes « drain », « source » et « grille » seront ainsi utilisés dans la suite de la description à la place des termes « première borne », « deuxième borne » et « borne de commande ».

Pour chaque interrupteur 104₁, 104₁', 104₂, 104₂', Le drain D₁, D₁', D₂, D₂' et la source S₁, S₁', S₂, S₂' présentent entre eux une tension drain-source Vds₁, Vds₁', Vds₂, Vds₂'. La grille G₁, G₁', G₂, G₂' et la source S₁, S₁', S₂, S₂' présentent entre elles une tension grille-source Vgs₁, Vgs₁', Vgs₂, Vgs₂' contrôlant en particulier la tension drain-source Vds₁, Vds₁', Vds₂, Vds₂'.

Pour chaque bras de commutation 102₁, 102₂, la source de l'interrupteur de côté haut 104₁, 104₂ et le drain de l'interrupteur de côté bas 104₁', 104₂' sont connectés l'un à l'autre en un point milieu (représenté par des pointillés sur la figure 1) destiné à être connecté à une bobine d'une machine électrique telle qu'un moteur électrique.

Les bras de commutation 102₁, 102₂ sont connectés à une source de tension continue 108, telle qu'une batterie ou un condensateur chargé, fournissant une tension Vb. Plus précisément, pour chaque bras de commutation 102₁, 102₂, le drain D₁, D₂ de l'interrupteur de côté haut 104₁, 104₂ est connecté à une borne positive de la source de tension continue 108, tandis que la source S₁', S₂' de l'interrupteur de côté bas 104₁', 104₂' est connecté à une borne négative (connectée généralement à une masse électrique) de la source de tension continue 108. Ces connexions à la source de tension continue 108 ne sont pas parfaites et impliquent la présence d'une inductance parasite 110 entre les bras de commutation 102₁, 102₂ et la source de tension continue 108.

Le convertisseur électrique 100 comporte en outre, pour chaque interrupteur 104₁, 104₁', 104₂, 104₂', un circuit de commande 112₁, 112₁', 112₂, 112₂' respectif.

Sur la figure 1 et dans la description qui va suivre, seul le circuit de commande 112₁ de l'interrupteur de côté haut 104₁ est détaillé, sachant que les autres circuits de commande 112₁', 112₂, 112₂' sont identiques.

Le circuit de commande 112₁ comporte tout d'abord un pilote 116₁ conçu pour fournir une tension de commande Vc₁ prenant sélectivement une première valeur de fermeture de l'interrupteur de côté haut 104₁ (10V dans l'exemple décrit) et une deuxième valeur d'ouverture de l'interrupteur de côté haut 104₁ (nulle dans l'exemple décrit).

Le circuit de commande 112₁ comporte en outre une interface 118₁ conçue pour définir des vitesses différentes de fermeture et d'ouverture de l'interrupteur de côté haut 104₁.

Plus précisément, l'interface 118₁ comporte une première connexion de commande CA₁ connectant le pilote 116₁ à la grille G₁. La connexion de commande CA₁ est destinée à être parcourue, lors de l'ouverture de l'interrupteur 104₁, par un courant de décharge de la grille G₁. Dans l'exemple décrit, la première connexion de commande CA₁ comporte une première résistance 120₁ définissant une vitesse d'ouverture de l'interrupteur 104₁ et une première diode 122₁ agencée pour empêcher du courant de s'écouler dans la première connexion de commande CA₁ jusqu'à la grille G₁.

L'interface 118₁ comporte en outre une deuxième connexion de commande CB₁ connectant le pilote 116₁ à la grille G₁. La connexion de commande CB₁ est destinée à être parcourue, lors de la fermeture de l'interrupteur 104₁, par un courant de charge de la grille G₁. Dans l'exemple décrit, la deuxième connexion de commande CB₁ comporte une deuxième résistance 124₁ définissant une vitesse de fermeture de l'interrupteur 104₁ et une deuxième diode 126₁ agencée pour empêcher du courant de s'écouler dans la deuxième connexion de commande CB₁ jusqu'au pilote 116₁.

Ainsi, les diodes 122₁, 126₁ permettent de s'assurer que la résistance souhaitée 120₁, 124₁ est utilisée pour respectivement l'ouverture et la fermeture de l'interrupteur de côté haut 104₁.

En outre, la deuxième résistance 124₁ et la première résistance 120₁ ont de préférence des valeurs différentes de manière à définir des vitesses différentes d'ouverture et de fermeture.

Le circuit de commande 112₁ comporte en outre un circuit de limitation de tension 128₁ (de l'anglais *« active clamping »*) conçu pour limiter la tension drain-source Vds₁.

Dans l'exemple décrit, le circuit de limitation de tension 128₁ comporte une diode Zener 130₁, une résistance 132₁ et une diode 134₁ montés en série entre une première borne 136₁ et une deuxième borne 138₁, une tension d'entrée V₁ étant destinée à être présentée sur la deuxième borne 138₁ par rapport à la première borne 136₁.

Ainsi, en négligeant la tension de seuil de la diode 134₁, lorsque la tension V₁ est inférieure à une tension de claquage Vz de la diode Zener 130₁, cette dernière est dans sa zone bloquante et empêche l'entrée de courant par la deuxième borne 138₁. De son côté, la diode 134₁ empêche l'entrée de courant par la première borne 136₁. Ainsi, le circuit de limitation de tension 128₁ est dans un mode passif dans lequel il est conçu pour se comporter comme un circuit ouvert (résistance très élevée entre les deux bornes 136₁, 138₁, par exemple d'au moins 100 kΩ, de préférence d'au moins 1 MΩ). En particulier, dans ce mode passif, le circuit de limitation de tension 128₁ est conçu pour ne pas contraindre la tension V₁.

Lorsque la tension V₁ atteint la tension de claquage Vz, la diode Zener 130₁ entre dans sa zone de claquage et laisse entrer du courant par la deuxième borne 138₁ qui sort par la première borne 136₁. En outre, la tension V₁ est maintenue par la diode Zener 130₁ relativement constante, égale à sa tension de claquage Vz. Ainsi, le circuit de limitation de tension 128₁ est dans un mode actif dans lequel il est conçu pour présenter une résistance très faible (par exemple inférieure à 100 Ω, de préférence inférieure à 10 Ω) et donc pour contraindre la tension V₁ à une valeur proche de la tension de claquage Vz.

La deuxième borne 138₁ est connectée au drain D₁ et la première borne 136₁ est connectée à la grille G₁ par une connexion de rétroaction CR₁ (représentée en trait épais sur la figure 1). Plus précisément, la première borne 136₁ est connectée à la première connexion de commande CA₁ de l'interface 118₁, du côté bloquant de la diode 122₁. Ainsi, la première connexion de commande CA₁ et la connexion de rétroaction CR₁ présentent une partie commune comportant la diode 122₁. Ainsi, la diode 122₁ empêche le courant i₁ fourni par le circuit de limitation de tension 128₁ de s'écouler dans la connexion de rétroaction CR₁ jusqu'à la grille G₁.

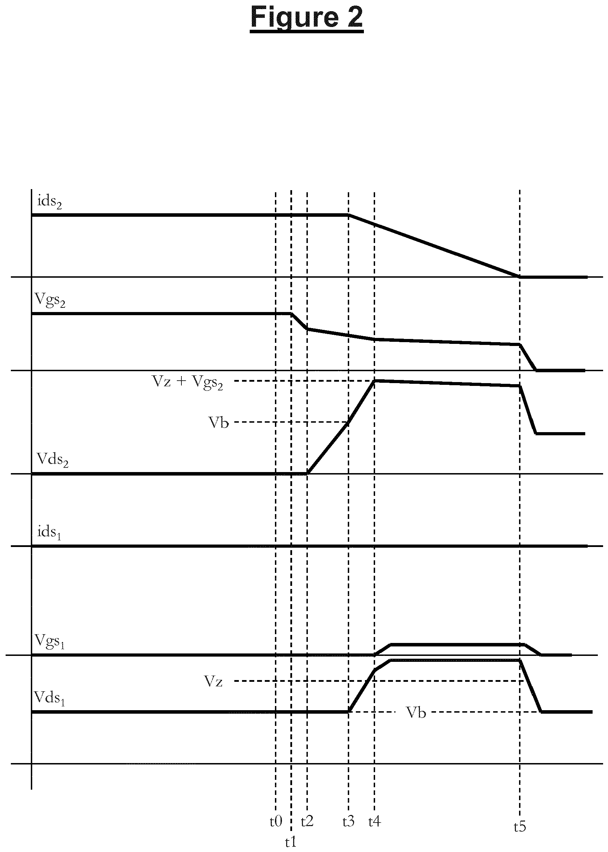

En référence à la figure 2, le fonctionnement du système électrique 100 lors de l'ouverture de l'interrupteur 104₂, alors que l'interrupteur 104₁ est à l'état fermé, va à présent être décrit. Par la suite, les tensions de seuil des diodes sont négligées.

Initialement, avant un instant t0, dans le premier bras de commutation 102₁, l'interrupteur de côté haut 104₁ est à l'état ouvert (courant de drain id₁ nul et tension grille-source Vgs₁ nulle) et l'interrupteur de côté bas 104₁' est à l'état fermé (tension drain-source Vds₁' nulle). Dans le deuxième bras de commutation 102₂, l'interrupteur de côté haut 104₂ est à l'état fermé (courant de drain id₂ constant du fait de l'inductance importante des bobines de la machine électrique, tension grille-source Vgs₂ constante et tension drain-source Vds₂ nulle) et l'interrupteur de côté bas 104₂' est à l'état ouvert (tension drain-source Vds₂' égale à la tension Vb). En outre, l'inductance 110 est parcouru par un courant d'inductance i_{L} égal à au courant de drain id₂ et donc constant. L'inductance 110 présente de ce fait une tension d'inductance V_{L} nulle.

À un instant t0, le pilote 116₂ commande la fermeture de l'interrupteur de côté haut 104₂ et applique à l'interface 118₂ une tension de commande Vc₂ nulle.

À un instant t1, après un temps de retard (t1-t0), la tension grille-source Vgs₂ commence à diminuer.

À un instant t2, la tension grille-source Vgs₂ atteint un seuil et provoque de ce fait l'augmentation de la tension drain-source Vds₂. Parallèlement, comme les deux interrupteurs 104₂, 104₂' sont soumis à la tension Vb, la tension drain-source Vds₂' de l'interrupteur de côté bas 104₂' diminue.

À un instant t3, la tension drain-source Vds₂ devient supérieure à la tension Vb. La tension drain-source Vds₂' est alors nulle et la tension d'inductance V_{L} devient de plus en plus négative. De ce fait, le courant d'inductance i_{L} commence à diminuer. Comme le courant de drain id₂ est égal au courant d'inductance i_{L}, le courant de drain id₂ commence également à diminuer. En outre, la tension d'inductance V_{L} négative entraîne une surtension |V_{L}| s'ajoutant à la tension Vb entre le drain D₁ et la source S₁ de l'interrupteur de côté haut 104₁, de sorte que la tension drain-source Vds₁ commence à augmenter.

À un instant t4, la tension drain-source Vds₁ atteint la tension de claquage Vz de la diode Zener 130₁. Comme la tension grille-source Vgs₁ est nulle, la tension V₁ est égale à la tension drain-source Vds₁ et atteint donc également la tension de claquage Vz, de sorte que le circuit de limitation de tension 128₁ devient actif. Un courant i₁ sort donc de sa première borne 136₁. Grâce à la présence de la diode 122₁, ce courant i₁ ne s'écoule pas vers la grille G₁ et ne vient donc pas charger cette dernière. Au contraire, le courant i₁ traverse la résistance 120₁ pour s'écouler vers la source S₁. Généralement, le pilote 116₁ présente une résistance interne non nulle, mais faible devant la résistance 120₁ et la résistance 124₁ (au moins 10 fois inférieure). De ce fait, une petite partie du courant i₁ rejoint la grille G₁ au travers de la diode 126₁ et de la résistance 124₁, entraînant une légère augmentation de la tension grille-source Vgs₁. Cependant, cette augmentation de la tension grille-source Vgs₁ n'est pas suffisante pour provoquer une reconduction notable de l'interrupteur de côté haut 104₁. Ainsi, le courant de drain id₁ reste nul.

À un instant t5, la tension drain-source Vds₂ atteint la somme de la tension de claquage Vz et de la tension grille-source Vgs₂ et le circuit de limitation de tension 128₂ devient actif et réalise la rétroaction suivante. Lorsque la tension drain-source Vds₂ augmente, la tension grille-source Vgs₂ augmente également car la tension drain-grille Vdg₂ est maintenue relativement constante par le circuit de limitation de tension 128₂ Or, cette augmentation de la tension grille-source Vgs₂ tend à faire baisser la tension drain-source Vds₂. Ainsi, la tension drain-source Vds₂ est limitée.

À un instant t6, le courant d'inductance i_{L} s'annule et reste nulle. Ainsi, la tension d'inductance V_{L} devient elle aussi nulle. La tension grille-source Vgs₂ diminue jusqu'à zéro et la tension drain-source Vds₂ diminue jusqu'à la tension Vb.

La présente invention n'est pas limitée aux modes de réalisation décrits précédemment, mais est au contraire définie par les revendications qui suivent. Il sera en effet apparent à l'homme du métier que des modifications peuvent y être apportées.

Par exemple, la résistance 120₁ pourrait être placée entre la diode 122₁ et la grille G₁.

Par ailleurs, les termes utilisés dans les revendications ne doivent pas être compris comme limités aux éléments des modes de réalisation décrits précédemment, mais doivent au contraire être compris comme couvrant tous les éléments équivalents que l'homme du métier peut déduire à partir de ses connaissances générales.

## Revendications

1. Système d'interrupteur comportant :
- un interrupteur (104₁) comportant :
- une première borne (D₁),
- une deuxième borne (S₁), et
- une borne de commande (G₁),
la première borne (D₁) et la deuxième borne (S₁) présentant entre elles une première tension (Vds₁),
la borne de commande (G₁) et la deuxième borne (S₁) présentant entre elles une deuxième tension (Vgs₁) contrôlant la première tension (Vds₁),
- un circuit de limitation de tension (128₁) comportant une première borne (136₁),
- une connexion de rétroaction (CR₁) entre la première borne (136₁) du circuit de limitation de tension (128₁) et la borne de commande (G₁) de l'interrupteur (104₁),
le circuit de limitation de tension (128₁) étant conçu pour, dans un mode actif, réaliser une rétroaction de la première tension (Vds₁) sur la deuxième tension (Vgs₁) de manière à limiter la première tension (Vds₁),
le circuit de limitation de tension (128₁) étant en outre conçu pour, dans son mode actif, fournir un courant (i₁) par sa première borne (136₁),
**caractérisé en ce qu'**il comporte en outre :
- un dispositif de blocage de courant (122₁) conçu pour empêcher le courant (i₁) fourni par le circuit de limitation de tension (128₁) de s'écouler dans la connexion de rétroaction (CR₁) jusqu'à la borne de commande (G₁) de l'interrupteur (104₁).

2. Système d'interrupteur selon la revendication 1, dans lequel la connexion de rétroaction (CR₁) comporte le dispositif de blocage de courant (122₁).

3. Système d'interrupteur selon la revendication 2, comportant en outre une interface (118₁) comportant une première connexion de commande (CA₁) connectée, à une extrémité, à la borne de commande (G₁) de l'interrupteur (104₁) et conçue pour recevoir, à une autre extrémité, une tension de commande (Vc₁), la première connexion de commande (CA₁) ayant une partie commune avec la connexion de rétroaction (CR₁) et comportant une première résistance (120₁), ainsi que, sur cette partie commune, le dispositif de blocage de courant (122₁).

4. Système d'interrupteur selon la revendication 3, dans lequel l'interface (118₁) comporte en outre une deuxième connexion de commande (CB₁) connectée, à une extrémité, à la borne de commande (G₁) de l'interrupteur (104₁) et conçue pour recevoir, à une autre extrémité, la tension de commande (Vc₁), la deuxième connexion de commande (CB₁) comportant une deuxième résistance (124₁).

5. Système d'interrupteur selon la revendication 4, dans lequel la deuxième connexion de commande (CB₁) comporte en outre une diode (126₁) agencée pour empêcher du courant de s'écouler dans la deuxième connexion de commande (CB₁) depuis la borne de commande (G₁) de l'interrupteur (104₁).

6. Système d'interrupteur selon l'une quelconque des revendications 1 à 5, dans lequel le dispositif de blocage de courant (122₁) comporte une diode (122₁).

7. Système d'interrupteur selon l'une quelconque des revendications 1 à 6, dans lequel le circuit de limitation de tension (128₁) comporte une deuxième borne (138₁) connectée à la première borne (D₁) de l'interrupteur (104₁) et une diode Zener (130₁) agencée, avant claquage, pour empêcher du courant d'entrer dans le circuit de limitation de tension (128₁) par sa deuxième borne (138₁).

8. Système d'interrupteur selon l'une quelconque des revendications 1 à 7, dans lequel le circuit de limitation de tension (128₁) comporte une diode (134₁) agencée pour empêcher du courant d'entrer dans le circuit de limitation de tension (128₁) par sa première borne (136₁).

9. Système d'interrupteur selon l'une quelconque des revendications 1 à 8, dans lequel l'interrupteur (104₁) comporte un MOSFET.

10. Convertisseur électrique (100) comportant au moins deux bras de commutation (102₁, 102₂) ayant chacun deux interrupteurs (104₁, 104₁' ; 104₂, 104₂') connectés l'un à l'autre en un point milieu, et dans lequel chacun d'au moins un des interrupteurs (104₁, 104₁' ; 104₂, 104₂'), de préférence tous, fait partie d'un système d'interrupteur selon l'une quelconque des revendications 1 à 9.
